# EUROPEAN PATENT SPECIFICATION

(11) **EP 3 178 118 B1**
(45) Date of publication and mention of the grant of the patent: **18.05.2022**
(21) Application number: 15750564.5
(22) Date of filing: 05.08.2015
(51) Int. Cl.: H01L 33/50

(54) **MULTI-LAYER CONVERSION MATERIAL FOR DOWN CONVERSION IN SOLID STATE LIGHTING**
MEHRLAGIGE KONVERSIONSMATERIAL FÜR LICHTUMWANDLUNG IN FESTKÖRPERBELEUCHTUNG
MATÉRIAU DE CONVERSION MULTICOUCHE POUR CONVERSION LUMINEUSE DANS UN ÉCLAIRAGE ÉLECTROLUMINESCENT

(30) Priority: 06.08.2014 US 201414453482
(43) Date of publication of application: 14.06.2017
(73) Proprietor: CreeLED, Inc., Newark, CA 94560 (US)
(72) Inventor: ZHANG, Fan, Goleta, CA 93117 (US); IBBETSON, James, Santa Barbara, CA 93111 (US); KELLER, Bernd, Santa Barbara, CA 93111 (US); LOWES, Theodore, Lompoc, CA 93436 (US); VAN DE VEN, Antony, Hong Kong (CN); KIRCHER, Deborah, Santa Barbara, CA 93105 (US); GILBERT, Tao Feng, Goleta, CA 93117 (US)
(74) Representative: Modiano, Gabriella Diana
(86) International application number: PCT/US2015/043840
(87) International publication number: WO 2016/022707

(56) References cited:
- EP-A1- 2 293 353
- US-A1- 2011 228 514
- US-A1- 2012 032 219
- US-A1- 2013 328 074
- ZONG-TAO LI ET AL: "Detailed Study on Pulse-Sprayed Conformal Phosphor Configurations for LEDs", JOURNAL OF DISPLAY TECHNOLOGY, IEEE SERVICE CENTER, NEW YORK, NY, US, vol. 9, no. 6, 1 June 2013 (2013-06-01), pages 433-440, XP011506547, ISSN: 1551-319X, DOI: 10.1109/JDT.2012.2225019

## Description

This application refers to U.S. Patent Application Serial No. 13/028,863, to Tong et al., filed on February 16, 2011, and U.S. Patent Application Serial No. 13/649,052, to Lowes et al., filed on October 10, 2012.

### BACKGROUND OF THE INVENTION

### Field of the Invention

This invention relates to solid state light sources and in particular to efficient and reliable light emitting diode (LED) packages having enhanced emission characteristics through separation of different phosphor components.

### Description of the Related Art

Incandescent or filament-based lamps or bulbs are commonly used as light sources for both residential and commercial facilities. However, such lamps are highly inefficient light sources, with as much as 95% of the input energy lost, primarily in the form of heat or infrared energy. Compact Fluorescent Lamps are more effective than incandescent at converting the electricity into light but require the use of toxic materials such as Hg such that when the lamps are disposed of these toxic materials that can pollute the environment, including underground water supplies. One solution for improving the efficiency of lamps or bulbs is to use solid state devices such as light emitting diodes (LED or LEDs), rather than metal filaments, to produce light.

Light emitting diodes generally comprise one or more active layers of semiconductor material sandwiched between oppositely doped layers. When a bias is applied across the doped layers, holes and electrons are injected into the active layer where they recombine to generate light. Light is emitted from the active layer and from all surfaces of the LED.

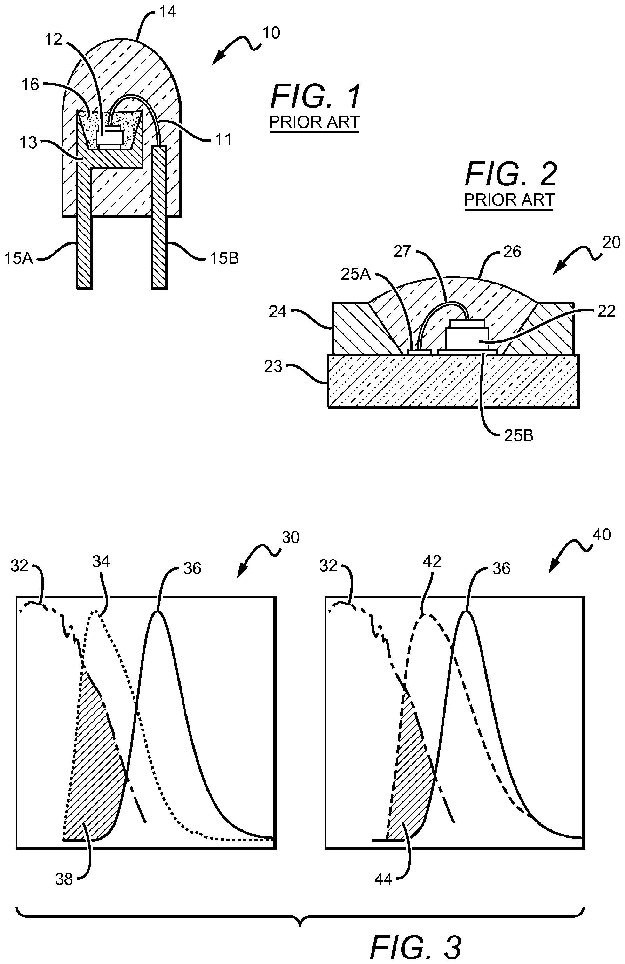

In order to use an LED chip in a circuit or other like arrangement, it is known to enclose an LED chip in a package to provide environmental and/or mechanical protection, color selection, light focusing and the like. An LED package also includes electrical leads, contacts or traces for electrically connecting the LED package to an external circuit. In a typical LED package 10 illustrated in FIG. 1, a single LED or LED chip 12 is mounted on a reflective cup 13 by means of a solder bond or conductive epoxy. One or more wire bonds 11 connect the ohmic contacts of the LED chip 12 to leads 15A and/or 15B, which may be attached to or integral with the reflective cup 13. The reflective cup may be filled with an encapsulant material 16 which may contain a wavelength conversion material such as a phosphor. Light emitted by the LED at a first wavelength may be absorbed by the phosphor, which may responsively emit light at a second wavelength. The entire assembly is then encapsulated in a clear protective resin 14, which may be molded in the shape of a lens to collimate the light emitted from the LED chip 12. While the reflective cup 13 may direct light in an upward direction, optical losses may occur when the light is reflected (i.e. some light may be absorbed by the reflective cup due to the less than 100% reflectivity of practical reflector surfaces). In addition, heat retention may be an issue for a package such as the package 10 shown in FIG. 1a, since it may be difficult to extract heat through the leads 15A, 15B.

A conventional LED package 20 illustrated in FIG. 2 may be more suited for high power operations which may generate more heat. In the LED package 20, one or more LEDs 22 are mounted onto a carrier such as a printed circuit board (PCB) carrier, substrate or submount 23. A metal reflector 24 mounted on the submount 23 surrounds the LED chip(s) 22 and reflects light emitted by the LEDs 22 away from the package 20. The reflector 24 also provides mechanical protection to the LEDs 22. One or more wire bond connections 27 are made between ohmic contacts on the LED chips 22 and electrical traces 25A, 25B on the submount 23. The mounted LEDs 22 are then covered with an encapsulant 26, which may provide environmental and mechanical protection to the chips while also acting as a lens. The encapsulant 26 can also comprise one or more convention materials (e.g. phosphors) that absorb light from the LED chips and re-emit light with different wavelengths of light. The overall emission from the package 20 can be a combination of light from the LEDs 22 and the re-emitted light from the conversion material. The metal reflector 24 is typically attached to the carrier by means of a solder or epoxy bond.

LEDs, such as those found in the LED package 20 of FIG. 2 can also be coated by conversion material comprising one or more phosphors, with the phosphors absorbing at least some of the LED light. The LED can emit a different wavelength of light such that it emits a combination of light from the LED and the phosphor. The LEDs can be coated with a phosphor using many different methods, with one suitable method being described in U.S. Patent Applications Serial Nos. 11/656,759 and 11/899,790, both to Chitnis et al. and both entitled "Wafer Level Phosphor Coating Method and Devices Fabricated Utilizing Method". Alternatively, the LEDs can be coated using other methods such as electrophoretic deposition (EPD), with a suitable EPD method described in U.S. Patent Application No. 11/473,089 to Tarsa et al. entitled "Close Loop Electrophoretic Deposition of Semiconductor Devices".

Lamps have also been developed utilizing solid state light sources, such as LEDs, with a conversion material that is separated from or remote to the LEDs. Such arrangements are disclosed in U.S. Patent No. 6,350,041 to Tarsa et al., entitled "High Output Radial Dispersing Lamp Using a Solid State Light Source." The lamps described in this patent can comprise a solid state light source that transmits light through a separator to a disperser having a phosphor. The disperser can disperse the light in a desired pattern and/or changes its color by converting at least some of the light through a phosphor. In some embodiments the separator spaces the light source a sufficient distance from the disperser such that heat from the light source will not transfer to the disperser when the light source is carrying elevated currents necessary for room illumination. Additional remote phosphor techniques are described in United States Patent No. 7,614,759 to Negley et al., entitled "Lighting Device."

The coated LEDs, LED packages and solid state lamps described above can utilize more than one type of conversion material, such as phosphors, to produce the desired overall emission temperature and CRI. Each of the phosphors can absorb light from the LED and re-emit light at a different wavelength of light. Some of these conventional arrangements can utilize a green/yellow phosphor, in combination with a red or orange phosphor, with these phosphors typically absorbing blue LED light and emitting green/yellow and red light, respectively. The re-emitted light can combine with blue LED light to produce the desired emission characteristics.

These conventional arrangements typically mix the different phosphors together at one location, such as in the LED coating, LED package encapsulant, or lamp remote phosphor. One disadvantage of mixing the phosphors together is that there can be significant "cross-talk" or "overlap" between the emission and excitation spectrum for the different phosphors, which can negatively impact the CRI and emission efficiency for the combined emitted light. FIG. 3 shows graphs 30 showing one example of the emission and excitation characteristics for conventional phosphors that can be mixed together. The first graph 30 shows the red phosphor excitation spectrum 32, green phosphor emission spectrum 34, and the red emission spectrum 36. The second graph 40 shows the same red phosphor emission excitation spectrum 32, yellow phosphor emission spectrum 42, and the same red phosphor emission spectrum 36. The shaded overlap regions 38, 44 show the portion of the green and yellow emission spectrums 34, 42 that overlap the red excitation spectrum 32. This overlap can result in "re-absorption" of the converted yellow/green phosphor light by the red phosphor. This converts a portion of the yellow/green that would otherwise contribute to overall emission, to red. In lighting components using these phosphors to produce a white light combination from the LED and phosphors, the re-absorption distorts the resulting white light on the black body curve of a CIE graph such that the yellow/green peak emission can shift to red, and the red peak can shift to blue. This can result in a CRI reduction in the overall emission. There is also some efficiency loss associated with the phosphor absorption and emission process, and repeating this process through re-absorption of the yellow/green light by the red phosphor results in additional efficiency losses.

ZONG-TAO LI ET AL, "Detailed Study on Pulse-Sprayed Conformal Phosphor Configurations for LEDs", JOURNAL OF DISPLAY TECHNOLOGY, IEEE SERVICE CENTER, NEW YORK, (20130601), vol. 9, no. 6, ISSN 1551-319X, pages 433-440 discloses conformal-shaped phosphor coating fabricated using pulsed spray techniques on horizontal LED chips. The LED devices have an LED chip mounted on a substrate, a first conformal red nitride phosphor coating on the chip and partially on the substrate, a second conformal yellow green phospshor coating on the first coating and an encapsulating layer over the submount, chip and conformal layers.

US2013/328074 discloses an LED package with a plurality of LED chips mounted on a submount, a conversion material layer blanket covering the LED chips and an encapsulant convering the submount LED chips and conversion layer. The conversion layer can be arranged with more than one phosphor material.

### SUMMARY OF THE INVENTION

The present invention is directed to different LEDs having conversion materials arranged in a layered fashion to improve the LEDs' characteristics. Some of these characteristics include improved emission intensity and color rendering index (CRI), while others can include a reduction in the amount of costly conversion material needed to reach a desired color point or CRI. According to the invention the different conversion material layers are arranged so that respective layers absorb light from the LED light source and re-emit light in different wavelength spectrum. According to the invention, the layers are tailored so that there is minimal overlap of the emission and excitation spectrums for the conversion materials in the layers.

One embodiment of an LED according to the present invention is defined in appended claim 1.

These and other aspects and advantages of the invention will become apparent to those skilled in the art from the following detailed description and the accompanying drawings, which illustrate by way of example the features of the invention.

### BRIEF DESCRIPTION OF THE DRAWINGS

FIG. 1 shows a sectional view of one embodiment of a prior art LED lamp;
FIG. 2 shows a sectional view of another embodiment of a prior art LED lamp;
FIG. 3 is a graph showing overlap between the excitation spectrum and emission spectrum of two phosphors;
FIG. 4 is a top perspective view of one embodiment of an LED according to the present invention;
FIG. 5 is a bottom perspective view of the LED shown in FIG. 4;
FIG. 6 is a front view of the LED shown in FIG. 4;
FIG. 7 is left side view of the LED shown in FIG. 4;
FIG. 8 is a back view of the LED shown in FIG. 4;
FIG. 9 is a right side view of the LED shown in FIG. 4;
FIG. 10 is a top view of the LED shown in FIG 4;
FIG. 11 is bottom view of the LED shown in FIG. 4;
FIG. 12 is a graph showing relationship between the emission spectrum for an LED and the emission and excitation spectrum for phosphors in one embodiment of an LED according to the present invention;
FIG. 13 is a table showing the concentrations of phosphors for one embodiment of an LED according to the present invention in comparison to an LED with mixed conversion materials;
FIG. 14 is a table showing the ratios of concentrations of phosphors for one embodiment of an LED according to the present invention in comparison to an LED with mixed conversion materials;
FIG. 15 is a graph showing the emission spectrum for an LED according to the present invention compared to an LED with mixed conversion materials;
FIG. 16 is a graph showing the emission spectrum for a LED according to the present invention compared to an LED with mixed conversion materials;
FIG. 17 is a graph showing the emission characteristics for an LED according to the present invention over temperature compared to an LED with mixed conversion materials;
FIG. 18 is a perspective view of one embodiment of an LED according to the present invention;
FIG. 19 is a sectional view of the LED shown in FIG. 17 taken along section lines 18-18;
FIG. 20 is a sectional view of an LED not forming part of the invention;
FIG. 21 is a sectional view of an LED_ not forming part of the invention
FIG. 22 is a sectional view of an LED not forming part of the invention
FIG. 23 is a sectional view of of an LED not forming part of the invention ;
FIG 24 is a top view of another embodiment of an LED at one of its manufacturing steps; and
FIG. 25 is a top view of the LED chip in FIG. 24 at a subsequent manufacturing step.

### DETAILED DESCRIPTION OF THE INVENTION

The present invention is directed to solid state emitters, such as light emitting diodes (LED or LEDs) that utilize multiple conversion materials or phosphor types in the conversion process in order to achieve the desired emission color point. Different embodiments of the present invention apply the different phosphor types in separate layers on or above a plurality of LED chips to achieve the desired light down conversion. The LEDs can then emit a desired combination of light from the LED chips and conversion material, such as a white light combination.

The phosphor layer, or any wavelength conversion layer, can convert a portion of the light emitted from the LED chip to a different wavelength, a process that is known in the art. One example of this process, is converting a portion of blue-emitted light from an LED chip, to yellow/green and red light. As further described below, there are many different phosphors that can be used for this type of light conversion.

According to the invention, conversion materials are applied as layers of different phosphor types in order of longest emission wavelength phosphor first (e.g. red), followed by shorter emission phosphors (e.g. yellow or green) in sequence as opposed to applying in a homogeneously mixed phosphor converter. The conversion material layers are applied as a blanket over the LED chips and the area surrounding the chip, such as the surface of the submount holding the LED chips. The advantages that can be realized with embodiments according to the present invention can include, but is not limited to, improved efficiency at the same color rendering index (CRI), enhanced CRI at the same efficiency, and a reduction in the quantity of certain phosphors needed to achieve a given color target. For example, red phosphors are relatively expensive and in the case where less red phosphors are used the cost savings can be significant.

Some conversion materials can be arranged in different embodiments described herein to achieve the desired emission efficiency (e.g. lumens per watt (LPW)). This discrete layer arrangement can also be optimized to achieve the desired CRI, R9, Qg, thermal quenching, etc. For some embodiments directed to optimized thermal quenching, the most temperature sensitive conversion material can be placed on the LED surface for improved heat sinking.

The layered arrangements according to the present invention can provide for conversion materials separation to reduce the impact of emission and excitation spectrum overlap. Embodiments of the present invention are directed to LEDs arranged to produce white light with a warm color temperature by utilizing two separate phosphor components in a way that eliminates or reduces the re-absorption (interaction) between the two component phosphors. That is, the separation reduces the amount of light from the first phosphor that interacts with the second phosphor, to reduce or eliminate the re-absorption by the second phosphor. This in turn reduces the color shift in CRI and losses that may be experienced by this re-absorption. This can result in improved emission efficiency of warm white light with a CRI that is significantly higher than those arrangements where re-absorption is not addressed, such as where the different phosphors are mixed.

According to the invention, the first phosphor re-emits a wavelength of light that does not overlap with the excitation spectrum of the second phosphor such that light re-emitted from the first phosphor passes through the second phosphor without risk of being absorbed by the second phosphor. The emission spectrum of the second phosphor, however, may emit light that at least partially overlaps with the excitation spectrum of the first phosphor. In arrangements where light from the second phosphor passes through the first phosphor, there may be a risk of light from the second phosphor being re-absorbed by the first phosphor. The separation of the phosphors minimizes the amount of re-emitted light that encounters the first phosphor, thereby minimizing the amount of light that can be re-absorbed by the first phosphor. To allow light from the first phosphor to pass through the second phosphor, embodiments of the invention comprise materials such that the emission spectrum of the first phosphor does not overlap the excitation spectrum of the second phosphor.

According to the invention, the second phosphor comprises a yellow/green phosphor that absorbs blue light and re-emits yellow/green light, and the first phosphor comprises a red phosphor that absorbs blue light and emits red light, with the emission spectrum of the yellow/green phosphor overlapping the excitation spectrum of the red phosphor. As described in more detail below, these embodiments provide separation between the first and second phosphors in a way that minimizes the chances that the yellow/green phosphor emission would encounter the red phosphor, and as a result, there is little chance of re-emitted yellow/green light being reabsorbed by the red phosphor. Compared to the mixed phosphor arrangement, the phosphor separation results in overall lamp or package emission having a higher CRI and higher phosphor efficiency.

The separation can take many different forms that can provide different levels of reduction in crosstalk between the first and second phosphors. According to the invention the separation comprises separate layers on an LED chip, formed on top of each other, with each layer being a different one of the phosphors In an aspect not forming part of the invention, one of the phosphors can be separated from the others by an intervening layer, or the phosphor can be provided remote to the other phosphor. This remote arrangement can take many different forms. In an aspect not forming part of the invention , one of the phosphors can comprise a conformal coat over one or more LEDs and the second phosphor can be remote to the first phosphor, such as in the shape of dome over the LEDs. This arrangement reduces even further the chances of crosstalk between the first and second phosphors by further reducing the chances that light emitted from the second phosphor would encounter the first phosphor.

Embodiments according to the invention include two phosphors, each of which is provided in a separate layer as described above with yellow/green phosphor layer on red phosphor layer. In some of these embodiments the first layer can have two or more phosphors that are different but that both emit in the red wavelength spectrum. The second layer can also have two or more different phosphors that emit in the yellow/green emission spectrum. The different phosphor can be chosen to provide the desired LED emission characteristics.

The present invention is described herein with reference to certain embodiments according to the invention, but it is understood that the invention can be embodied in many different forms and should not be construed as limited to the embodiments set forth herein. In particular, the present invention is described below in regards to certain LED packages having multiple LED chips in different configurations, but it is understood that the present invention can be used for many other lamps having many different configurations , while remaining in the scope defined by the appended claims . Examples not forming part of the invention, of different lamps arranged in different ways are described below and in U.S. Provisional Patent application Serial No. 61/435,759, to Le et al., entitled "Solid State Lamp", filed on January 24, 2011

The components can have different shapes and sizes beyond those shown and different numbers , superior or equal to two, of LEDs can be included. The present invention is described herein with reference to conversion materials, phosphors, phosphor layers and related terms.

It is also understood that when an element such as a layer, region or substrate is referred to as being "on" another element, it can be directly on the other element or intervening elements may also be present. Furthermore, relative terms such as "inner", "outer", "upper", "above", "lower", "beneath", and "below", and similar terms, may be used herein to describe a relationship of one layer or another region. It is understood that these terms are intended to encompass different orientations of the device in addition to the orientation depicted in the figures. The phosphors are described herein with referenced to red, yellow or green emitting phosphors, but it is understood that this can include other colors close to these emission colors. For red, by example, this can include those close to red in the light spectrum, such as orange.

The LED packages can also have many different shapes beyond those described below, such as rectangular, and solder pads and attach pads can be arranged in many different ways. In other embodiments, the emission intensity of the different types of LED chips can be controlled to vary the overall LED package emission.

These components can have different shapes and sizes beyond those shown, and two or more LEDs are included. It is also understood that the embodiments described below utilize co-planar light sources, but it is understood that non co-planar light sources can also be used. It is also understood that an LED light source is comprised of multiple LEDs that may have different emission wavelengths. In multiple LED packages, the LEDs can be serially interconnected or can be interconnected in different serial and parallel combinations.

It is also understood that when a feature or element such as a layer, region, encapsulant or submount may be referred to as being "on" another element, it can be directly on the other element or intervening elements may also be present. Furthermore, relative terms such as "inner", "outer", "upper", "above", "lower", "beneath", and "below", and similar terms, may be used herein to describe a relationship of one layer or another region. It is understood that these terms are intended to encompass different orientations of the device in addition to the orientation depicted in the figures. Further, many of the embodiments of the present invention are shown with a "top" primary emission surface. It is understood that any one or more surfaces, including but not limited to a top surface, can be (or can combine to form) a primary emission surface. For example, a package can be designed to have a primary emission out a side emission surface.

Although the terms first, second, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Embodiments of the invention are described herein with reference to cross-sectional view illustrations that are schematic illustrations of embodiments of the invention. As such, the actual thickness of the layers can be different, and variations from the shapes of the illustrations as a result, for example, of manufacturing techniques and/or tolerances are expected. Embodiments of the invention should not be construed as limited to the particular shapes of the regions illustrated herein but are to include deviations in shapes that result, for example, from manufacturing. A region illustrated or described as square or rectangular will typically have rounded or curved features due to normal manufacturing tolerances. Thus, the regions illustrated in the figures are schematic in nature and their shapes are not intended to illustrate the precise shape of a region of a device and are not intended to limit the scope of the invention.

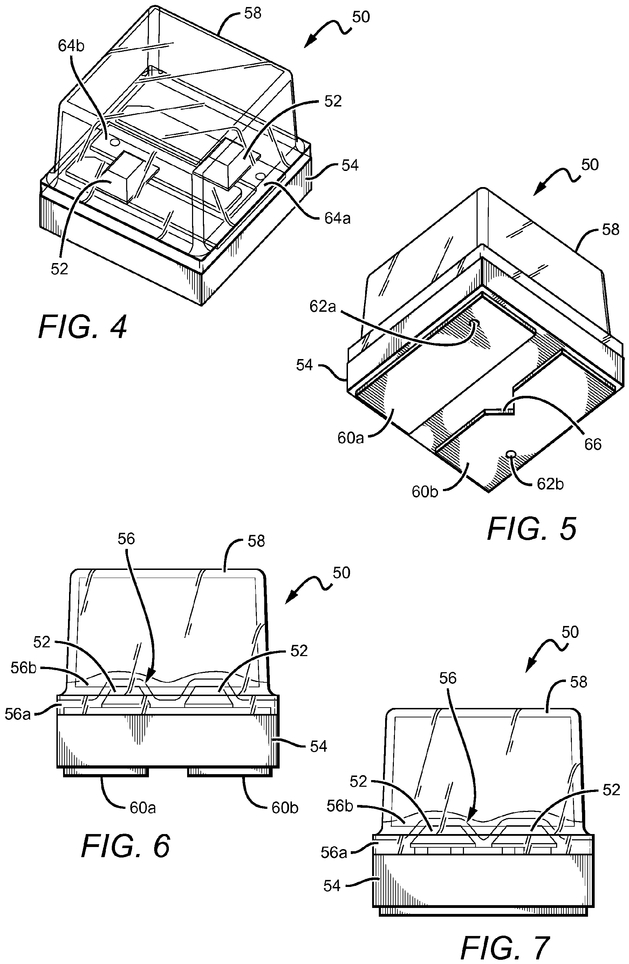

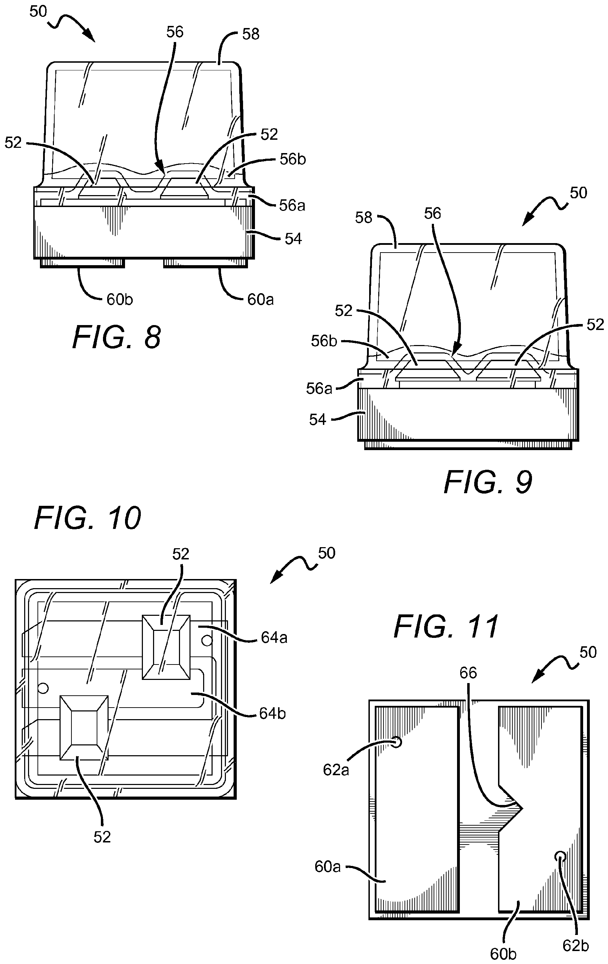

FIGS. 4 through 11 show one embodiment of an LED 50 according to the present invention comprising two or more LED chips 52, mounted on a submount 54. The LED 50 also comprises first and second bottom contact/solder pads 60a and 60b on the bottom of the submount 54, first and second conductive vias 62a, 62b passing through the submount 54, and first and second die attach pads 64a, 64b on the top surface of the submount 54. The LED package further comprises a conversion material layer 56 covering the LED chips 52, the exposed surfaces of the die attach pads 64a, 64*b*, and exposed portions of the top surface of the submount 54. An encapsulant 58 is included over the LED 52, the attach pads 64a, 64b, and the submount 54. FIGs. 4 and 11 show the LED chips 52, attach pads 64a, 64b, and top surface of the submount 54. It is understood that these features may be at least partially obscured by the conversion material layer described below. These features of the LED are shown unobscured for ease of description.

The LED 50 is shown with two LED chips 52 but it is understood that in other embodiments (such as those described below) the light source can comprise two LED chips or more than two LED chips, with some comprising a multiple LED chip array. Many different LED chips can be used such as those commercially available from Cree Inc., under its DA, EZ, GaN, MB, RT, TR, UT and XT families of LED chips. The LED 50 is particularly arranged for use with the DA family of LED chips such as the DA850 chip that can be flip chip mounted and allows for wire-free bonding. These types of chips are generally described in U.S. patent application Ser. No. 12/463,709 to Donofrio et al., entitled "Semiconductor Light Emitting Diodes Having Reflective Structures and Methods of Fabricating Same". The LED 50 can be arranged similar to the LED packages commercially available from Cree, Inc. under product names Xlamp XQ family of LEDs (e.g. Xlamp XQ-B LED). However, in this embodiment the phosphor is arranged in a discrete layered manner as opposed to the conventional mixed conversion material.

The LED chips 52 can emit many different colors of light, with a preferred LED chips 52 emitting light in the blue wavelength spectrum. It is understood that in some embodiments the LED chips can be provided following removal of its growth substrate. In other embodiments, the LED chip's growth substrate can remain on the LED chips 52 with some of these embodiments having a shaped or textured growth substrate. In some embodiments, the LED chips 52 can comprise a transparent growth substrate such as silicon carbide, sapphire, GaN, GaP, etc. The LED chips can also comprise a three dimensional structure and in some embodiments, the LEDs can have structures comprising entirely or partially oblique facets on one or more surfaces of the chip.

The LED 50 further comprises a submount 54, with the LED chips 52 mounted to the submount 54. The submount 54 can be formed of many different materials with a preferred material being electrically insulating, such as a dielectric material. The submount 54 can comprise a ceramic material such as alumina, aluminum nitride, silicon carbide, or a polymeric material such as polymide and polyester. In the preferred embodiment, the submount 54 can comprise a dielectric material having a relatively high thermal conductivity, such as aluminum nitride and alumina. In other embodiments the submount 54 can comprise a printed circuit board (PCB), sapphire or silicon or any other suitable material, such as T-Clad thermal clad insulated substrate material, available from The Bergquist Company of Chanhassen, Minn. For PCB embodiments different PCB types can be used such as standard FR-4 PCB, metal core PCB, or any other type of printed circuit board.

The top surface of the submount 54 is shown having a planar with patterned conductive features that can comprise first and second die attach pads 64a, 64*b*. A space is provided between the attach pads 64a, 64*b*, with the LED chips 52 mounted to the pads 64a, 64b such that respective portions of the LED chips 52 are mounted to a respective one of the pads 64a and 64b and the LED 52 spans the space between the attach pads 64a, 64*b*. Many different mounting methods can be used, such as methods utilizing conventional solder materials. Other types of LED chips can be electrically connected to the attach pads 64a, 64b or other conductive traces using known surface mount or wire bonding methods depending on the geometry of the LED 50.

The pads 64a, 64b can comprise many different materials, such as metals or other conductive materials, and in one embodiment they can comprise copper deposited using known techniques such as plating. In other embodiments pads 64a, 64b can be sputtered using a mask to form the desired pattern, and in other embodiments they can be formed using known photolithography processes. The pads 64a, 64*b* can extend beyond the edge of the LED chips 52 to cover most of the top surface of the submount 54. This helps in thermal management for the LED 50 by spreading heat from the LED chips 52 into the pads 64a, 64*b* so that heat spreads beyond the edge of the LED chips 52 into more area of the submount 54. This allows the heat to be less localized and allows it to more efficiently dissipate through the submount 54 into the ambient.

The LED 50 also comprises first and second solder pads 60a, 60*b* formed on the bottom surface of the submount 54, which can be used for mounting the LED package 52 in place using known mounting methods. It is understood that in other embodiments LEDs according to the present invention can have more than two solder pads. The solder pads 60a, 60b can be made of the same materials and can be formed of the same way as die attach pads 64a, 64*b*. First and second conductive vias 62a, 62b can be included that pass through the submount 54 with the vias being formed of an electrically conductive material such as those used for the die attach pads and solder pads, and are arranged to provide an electrically conductive path between the solder pads 60a, 60b and the die attach pads 64a, 64*b*. In the embodiment shown, first via 62a forms an electrically conductive path between the first solder pad 60a and the first die attach pad 64a, while second via 62b provides a conductive path between the second solder pad 60b and the second die attach pad 64*b*. This allows an electrical signal applied to the solder pads 60a, 60b to be conducted through the submount 54 along the vias 62a, 62*b*, to the die attach pads 64a, 64*b*. The signal is then conducted to the LED chips 52 through the die attach pads. It is understood that in other embodiments the electrical signal can be transmitted to the LED in other ways such as through conductive traces or wire bond pads arranged in different locations in the LED package, and running between the mounting surface or the submount, and the LED.

The LEDs 50 also comprises a polarity indicator 66 in one of the solder pads that can take many different shapes and can comprise a V-shaped notch along an edge of a solder. This polarity indicator 66 can be detected with up-looking cameras on automated pick-and-place equipment during manufacturing. The indicator 66 can be near the center of the pad's inner edge placing it near the center of the submount 54 in the area of the submount 54 that can be visible through hole in a carrier tape. This allows for the indicator 66 (and the corresponding LED package polarity) to be visible and verified carrier tape hole without removing the LED from the carrier tape.

The indicator 66 can have many different shapes beyond V-shaped, such as U-shaped, I-shaped, W-shaped, square shaped, rectangular shaped, star shaped, plus shaped, minus shaped, etc. The notch can also be included in many different locations on the solder pads 60a, *60b.* It is noted that other types of polarity indicators can be used, such as holes of different shapes or other cutouts in the solder pads, and in other embodiments the LED packages can have indicators in other locations such as on the top surfaces of the LED 50. In the embodiment shown, the second attach pad 64b can have an indicator to show polarity when viewing the LED package 50 from the top. These indicators can take many different shapes and sizes such as those described above, and in some embodiments can comprise notches or holes as described above.

The conversion material layer 56 is included over the LEDs 52, exposed portions of the pads 64a and 64*b*, and exposed portions of the submount's top surface. As described in more detail below, the conversion material layer comprises two or more conversion material layers, each of which has absorbs light from the LED chips 52 and reemits light in a different wavelength range.

Encapsulant 58 is included on the conversion material layer 56, and over the LED 52 and submount 54, with the encapsulant 58 providing environmental and mechanical protection. The encapsulant can take many different shapes and sizes, with some embodiments comprising a hemispheric encapsulant. In other embodiments, the encapsulant 58 can comprise planar surfaces, and in the embodiment shown the encapsulant 58 has a generally cubic shape. The encapsulant includes both vertical and horizontal planar surfaces in the shape of a cube, but it is understood that the encapsulant can take many different shapes such as any shape having a flat top and vertical sidewalls with planar surfaces. These can include but are not limited to different prismatic or polygon shapes such as triangles, pentagons, hexagons, octagons, etc. These shapes can include a horizontal planar surface, with vertical surfaces numbering in the range of 3 to 12 or more. In still other embodiments, the encapsulant can be cylindrical with different cross sections such as circular or oval. Encapsulants with planar surfaces and their advantages are fully described in U.S. Patent Application Serial No. 13/649,052, to Lowes et al.

Many different materials can be used for the encapsulant 58 such as silicones, plastics, epoxies or glass, with a suitable material being compatible with molding processes. Silicone is suitable for molding and provides suitable optical transmission properties. It can also withstand subsequent reflow processes and does not significantly degrade over time. The encapsulant can also be formed using many different methods, and in some embodiments a molding process (described in more detail below) can be used that simultaneously forms encapsulants 58 over a multitude of LEDs 52 on a submount panel.

The conversion material layer 56 can also comprise a binder, and different materials can be used for the binder, with materials preferably being robust after curing and substantially transparent in the visible wavelength spectrum. Suitable materials include silicones, epoxies, glass, inorganic glass, dielectrics, BCB, polymides, polymers and hybrids thereof, with the preferred material being silicone because of its high transparency and reliability in high power LEDs. Suitable phenyl- and methyl-based silicones are commercially available from Dow^{®} Chemical. The binder can be cured using many different curing methods depending on different factors such as the type of binder used. Different curing methods include but are not limited to heat, ultraviolet (UV), infrared (IR) or air curing. It is understood, however, that the phosphor particles can be applied without a binder.

For LED 50, the conversion material layer 56 comprises multiple layers having different conversion materials.

The conversion material layer comprises a bi-layer arrangement having a first layer 56a that absorbs light from the LED chips 52 and reemits light in the red wavelength spectrum. The conversion material layer 56 also comprises a second layer 56b that absorbs light from the LED chips 52 and reemits light in the yellow/green wavelength spectrum. It is understood that in some embodiments each of the layers 56a, 56b can comprise more than one conversion material type to generate the desired reemission wavelength. For example, the layer reemitting red can have more than one type of conversion material reemitting in the red spectrum. As described below, many different conversion materials can be used to generate the desired LED package light emission, with the present invention being particularly adapted to LED packages emitting white light.

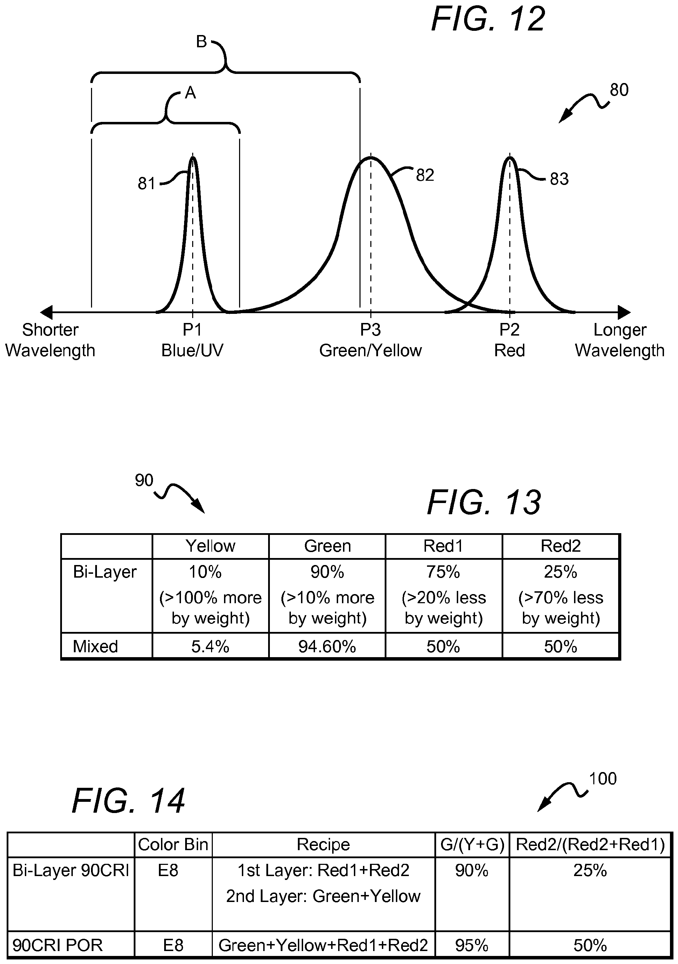

FIG. 12 is a graph 80 that further illustrates the relationship between emission and excitation wavelength ranges for different phosphor layers included over an LED according to the present invention. In the graph shorter wavelengths are on the left, while longer wavelengths are on the right. Curve 81 represents an exemplary emission spectrum of a blue or UV emitting LED chip such as those that could be used in LED 50. The emission spectrum 81 is centered around a peak wavelength P1 which falls in the blue or UV region of the visible spectrum. Curve 83 represents an exemplary emission spectrum of a phosphor such as can be found in the first conversion material layer 56a described above; i.e. the layer closest to the LED chip. The emission spectrum 83 is centered around a peak wavelength P2 which falls in the red region of the visible spectrum. Curve 82 represents an exemplary emission spectrum of a phosphor that can be found in the second conversion material layer 56b. The emission spectrum 82 is centered around a peak wavelength P3 which falls in the green to yellow region of the visible spectrum.

Graph 80 also shows excitation region A of the green/yellow phosphor and excitation region B of the red phosphor. The emission spectrum 81 of the LED chips may fall within a green/yellow phosphor excitation region A, which generates the emission spectrum 83. That is, the phosphor that emits light having the emission spectrum 82 (i.e. the green/yellow phosphor) can be responsive to light having a wavelength within the excitation region A. The emission spectrum 81 of the LED chips may also fall within a excitation region B of the red phosphor that generates the emission spectrum 83. That is, the phosphor that emits light having the emission spectrum 83 can be responsive to light having a wavelength within the excitation region B. It is understood excitation regions A and B illustrated in FIG. 12 may not have sharp boundaries, but may fall off gradually at the edges thereof as shown in FIG. 3 above. As used herein, a wavelength of light is within an excitation region of a phosphor if a visually perceivable amount of light is emitted by the phosphor in response to stimulation by light at the wavelength that is generated by an LED structure or that is generated in response to light emitted by an LED structure.

The emission spectrum 82 of the green/yellow phosphor can at least partially fall within the excitation region B of the red phosphor. That is, some light that is emitted by the green/yellow phosphor can be re-absorbed by the red phosphor. Such re-absorption can lead to losses, as some energy is lost in every phosphor absorption/emission cycle. The re-absorption can also alter the color point of the combined light output by the structure. However, as further illustrated in FIG. 12, the emission spectrum 83 of the red phosphor is outside the excitation region A of the green/yellow phosphor. Thus, light emitted by the red phosphor may not substantially be absorbed and cause responsive emission by the green/yellow phosphor. It will be appreciated that there may be some negligible absorption of red light by the green/yellow phosphor that may be converted into heat instead of light.

To reduce losses from re-absorption of emitted photons, to provide improved emission characteristics, and/or provide more consistent light output, embodiments according to the present invention separate the green/yellow phosphor from the red phosphor containing regions. A green/yellow phosphor layer is placed on the red phosphor layer so that light from the LED chip(s) passes through the red phosphor first. Unabsorbed blue light from the LED chip and red light generated in the red phosphor layer then pass through the green phosphor layer. However, primarily only the blue light from the LED chip is absorbed by the green/yellow to cause emission of green/yellow light thereby. The light from the red phosphor layer can pass through the green/yellow layer without being substantially absorbed.

The above example shown in FIG. 12 is related to a green/yellow phosphor layer on a red phosphor layer, but there can be many different phosphor layer arrangements according to comparative examples not forming part of the invention the present invention. The different embodiments of the invention include two or more phosphor layers and are arranged so that the emission spectrum of one or more of the layers below the top layer do not overlap at all with the excitation spectrum of one or more of the layers above. This present invention comprises two or more phosphor layers, and in those embodiments having more than two layers, the emission spectrum of one or both of layers below the top layer have an emission spectrum that does not overlap with the excitation spectrum of the top layer. In other embodiments, intervening layers can also be arranged according to the present invention. That is, a layer below the top layer has an excitation spectrum that does not overlap with the emission spectrum of a layer below it. There can be many layer arrangements that follow this general relationship of emission spectrum of a layer related to the excitation spectrum of a layer above.

In LED 50, the conversion material layer arrangement provides for increased emission efficiency by minimizing or eliminating the cross absorption of emitted light from the conversion materials. By separating the phosphors in a layer arrangement, as described above, instead of conventional mixing of the phosphors, the reabsorbs ion by an conversion material layer 56b of the emitted light of the lower phosphor layer 56a can be reduced or eliminated. In the case of a green/yellow conversion layer on a red conversion layer, the reabsorption of light from the green/yellow layer by the red conversion layer can be reduced or eliminated. This reabsorption can be further minimized by providing separation between the green/yellow layer and the red layer.

The conversion material layer can be applied using different processes including but not limited to spraying, dispensing, spin coating, sputtering, printing, powder coating, electrophoretic deposition (EPD), and electrostatic deposition, among others. These processes can also include a solvent in the phosphor-binder mixture that can liquefy and lower the viscosity of the mixture. Many different solvents can be used including but not limited to toluene, benzene, zylene, or OS-20 commercially available from Dow Corning^{®}, and different concentration of the solvent can be used. When the solvent-phosphor-binder mixture is sprayed, poured or dispersed heat from the remote phosphor evaporates the solvent and can also cure the binder in the mixture leaving a fixed phosphor layer. Various deposition methods and systems are described in U.S. Patent Application Publication No. 2010/0155763, to Donofrio et al., entitled "Systems and Methods for Application of Optical Materials to Optical Elements," and also assigned to Cree, Inc.

In LED 50, the first layer 56a is deposited such that it blanket covers the LED chips 52, the top surface of the submount 54 and the pads 64a, 64b. The second layer 56b is then deposited so that it covers the first layer 56a, thereby providing a bi-layer blanket coverage over the LEDs 52 submount 54 and pads 64a, 64b. LED chip light and converted light from the conversion material layer can emit toward the surface of the encapsulant 58. Some of this light will be reflected at the surface of the encapsulant by total internal reflection (TIR), and can be directed back toward the submount 54. This TIR light will encounter the blanket coverage conversion material layers 56a, 56b where the conversion material can again absorb and reemit at least some of the light. Without this blanket coverage, at least some of the TIR light would be absorbed at the submounts 54 or the pads 64a, 64b. The absorption and reemission of the TIR light can increase the chances that this light will escape from the encapsulant to contribute to LED emission; thereby increasing overall LED emission efficiency. This is referred to as photon recycling as fully described in U.S. Patent Application Serial No. 13/649, 052.

Different embodiments can comprise other elements arranged to increase emission efficiency. In some embodiments a reflective layer can be arranged in different locations and in different ways in LED packages according to the present invention. In some embodiments the reflective layer can be on the same surface of the submount having the LED chips. The reflective layer can at least partially surround the LED chips, and can cover the surface of the submount. In some embodiments, this surface of the submount can comprise the exposed surfaces of the die attach pads around the LED chips, the top surface of the submount around the LED chips and/or any electrostatic discharge (ESD) chip. In other embodiments where the conversion material layer covers the attach pads and submount, this reflective layer can be on the conversion material layer with the conversion material between the reflective layer and the submount. In still other embodiments, the conversion material layer can be on the reflective layer, with the reflective layer between the conversion material layer and the submount. In still other embodiments, the reflective layer can cover only selective portions of the submount, on selective ones of the die attach pads, wirebonds and any ESD chip. This type of reflective layer and its advantages are generally described in U.S. Patent Application Serial No. 14/183,218 to Reiherzer et al.

It is understood that in some embodiments, the bi-layer conversion material 56a, 56b can cover less than all of the top surface of the submount 54 and pads 64a, 64b. In comparative examples not forming part of the invention the bi-layer conversion material 56a, 56b can cover only the LED chips 52. In still other embodiments different ones of the bi-layers can cover different areas. According to the invention, the first layer 56a covers at least the LED chips 52, while the second layer 56b covers the LED chips and all or part of the top surface of the submount 54 and pads 64a, 64b. This arrangement still allows for the advantages of photon recycling as described above.

It is understood that in different embodiments intervening layers not having conversion materials can be included between the multiple conversion material layers. In some embodiments, these intervening layers can be substantially transparent and can be arranged to provide separation between different ones of the layers, to reduce emission or light from the different layers passing into others of the layers to further reduce reabsorption. The intervening layer(s) can also include materials to assist in scattering of the light from the LED. In some embodiments the intervening layers can comprise scattering particles or can be shaped or textured to assist in light scattering.

In some embodiments, the emission efficiency (or luminous flux measured in lumens per watt (LPW)) increase for LEDs according to the present invention with separated phosphors compared to the same LEDs with mixed phosphors, can be more than 20%. In other embodiments it can be greater than 10%, while in still other embodiments it can be greater than or approximately equal to 5%. In still other embodiments it can be in the range of 2-10%. For the embodiment shown in FIGs. 4 to 11 the increase in efficiency can be in the range of 2-10%, or approximately 5%.

The layering approach also provides further advantages such as achieving the same target emission characteristics in LED packages according to the present invention, while allowing for reduced amount of red phosphor in comparison to conventional LED chips with mixed phosphors. This can be particularly important in reducing costs based on the higher relative cost of red phosphors. In some embodiments, the same color (as measured by bin) can be achieved at the same color rendering index (CRI), using significantly less red phosphor. In some embodiments, the reduction in red phosphor compared to the same LED with mixed phosphors can be as high as approximately 75%. In other embodiments it can be as high as 50%, while in still other embodiments it can at high as 25%.

As mentioned above, different LED embodiments have discrete conversion material layers emitting in a particular spectrum, one layer in yellow/green and the other in red. These discrete layers can comprise more than one phosphor type to tune the conversion material layer to provide the desired LED emission characteristics. In some embodiments the yellow/green layer can have two or more different types of yellow/green emitting phosphors and the red layer can have two different or more different red phosphors.

FIG. 13 is a table 90 comparing one embodiment of a four phosphor recipe for the bi-layered conversion material layer that can be used in LEDs according to the present invention. This recipe is compared to the same four phosphors used in a conventional LED where the phosphors are mixed in a single conversion material layer, with table 90 showing the different amounts in percentages of overall phosphor in the layer for the phosphors so that each emits at substantially the same color point and CRI. The first layer closest to the LED chips can comprise two red phosphors identified as Red1 and Red2, with each emitting at different wavelengths in the red spectrum. The two red phosphors can comprise formulas known in the art with Red1 having a shorter emission wavelength compared to the emission wavelength of the Red2 phosphor. Red phosphors generally have peak emission wavelengths in the range of 620-750nm and in some embodiments, with some embodiment having red phosphors emitting light having peak emissions in the range of 620-670nm with a pattern having a full width at half maximum (FWHM) in the range of 70-100nm. In one embodiment, Red1 can have a peak emission wavelength of approximately 621nm and a full width at half maximum (FWHM) of approximately 80mn. Red2 can also have peak emission wavelength of approximately 651nm with a FWHM of approximately 90nm.

The second layer comprises yellow and green emitting phosphors, with some embodiments comprising a Y₃Al₅O₁₂:Ce yellow emitting phosphor and a Lu₃₋ₓCeₓAl₅O₁₂, Y (Y=Halide) green emitting phosphor. Green and yellow phosphors generally have peak emission wavelengths in the range of 495-590nm with green typically having a peak emission in the lower portion of this range and yellow having a peak emission in the higher end of this range. In some embodiments, the green and yellow phosphors emit peak emission wavelengths in the range of 520-580nm with FWHM in the range of 100-130nm. In some of these embodiments, the yellow emitting phosphor can have a peak emission wavelength of approximately 560nm and a FWHM of approximately 115nm. The green emitting phosphor can have a peak emission of approximately 534nm and a FWHM of approximately 110nm. It is understood that in other embodiments other phosphors can be used with other characteristics, and each of these phosphors can be provided in discrete layers such that the LED could have four phosphor layers. In these embodiments the two red phosphor layers can be closest to the LED chips. In still other embodiments, some of the phosphors can be mixed in a layer while others can be provided in discrete layers.

In the embodiment shown, the table 90 compares the amount of phosphors necessary in a two layer versus mixed conversion material to achieve target color point in for example the E8 bin, with a CRI of 90 (the LED chips can emit a blue dominant light with a wavelength of 450 and 456nm). In this embodiment, the bi-layer approach allows for these same emission characteristics as a mixed approach, while allowing for a reduction in red phosphors. In this embodiment, the bi-layer approach the phosphor Red2 can experience a decrease of approximately 25% ratio of the overall red phosphor mixture, and more importantly can experience a reduction of greater than 70% by weight compared to the mixed phosphor approach. The phosphor Red1 can experience an increase in its overall ratio of the red phosphor mixture, but can also experience greater than 20% reduction by weight compared to the mixed layer approach. This can result in significant cost reductions for the LED chip. It is noted that the bi-layer embodiments according to the present invention can also require more yellow and green phosphor, and can require more silicone for encapsulant. These increases can be acceptable based on the relatively low cost of yellow/green phosphors and silicone, and the significant cost of red phosphors.

The different amounts of red and yellow/green bi-layer phosphor approach also result in differences in phosphor ratios of the four phosphor approach compared to the conventional mixed approach. FIG. 14 is a graph 100 showing the different ratios of phosphors for the embodiment shown in FIG. 13 comparing the ratios of the yellow/green phosphors by the amount of green phosphor divided by the amount of green phosphor plus yellow phosphor. In this embodiment, the yellow/green ratio decreases from 95% to 90% for the mixed to bi-layer embodiments. FIG. 14 also compares the ratios of red phosphors by dividing the amount of Red2 red phosphor by the combination of the Red2 and Red1 phosphors. In this embodiment, their ratio decreases from 50% for the mixed to 25% for the bi-layer approach. This is only one of the many ways of comparing the different ratios of LED according to the present invention compared to mixed conversion LEDs.

FIGs. 13 and 14 are directed to comparing mixed and bi-layer conversion material LEDs emitting at the same color point and CRE by varying the phosphor amounts. It is also understood that for mixed and bi-layer LEDs using the same amount of phosphors, the LEDs can provide different emission characteristics. The bi-layer approach can result in an LED emitting with a higher CRI compared to the same LED with the same amount of mixed phosphors. In general, and LED emission with CRI of approximately 90% can be acceptable for many applications. When taking the phosphors from a mixed conversion material LED and using the same amounts in a bi-layer LED, the bi-layer LED chip can emit with a CRI in excess of 90. The excess CRI can be traded with other LED feature characteristics to achieve the acceptable 90 CRI while increasing efficiency. In some embodiments, the excess CRI can be traded with the wavelength of the red phosphor. That is, a lower wavelength emitting red phosphor can have a higher efficiency compared to higher wavelength phosphors, but can result in a lower CRI. The excess CRI can allow for the use of lower wavelength red phosphors that still allow for LED chip emission at the desired 90 CRI. This can also allow for increased emission efficiency compared to the same LED using a mixed conversion material layer with the same phosphors.

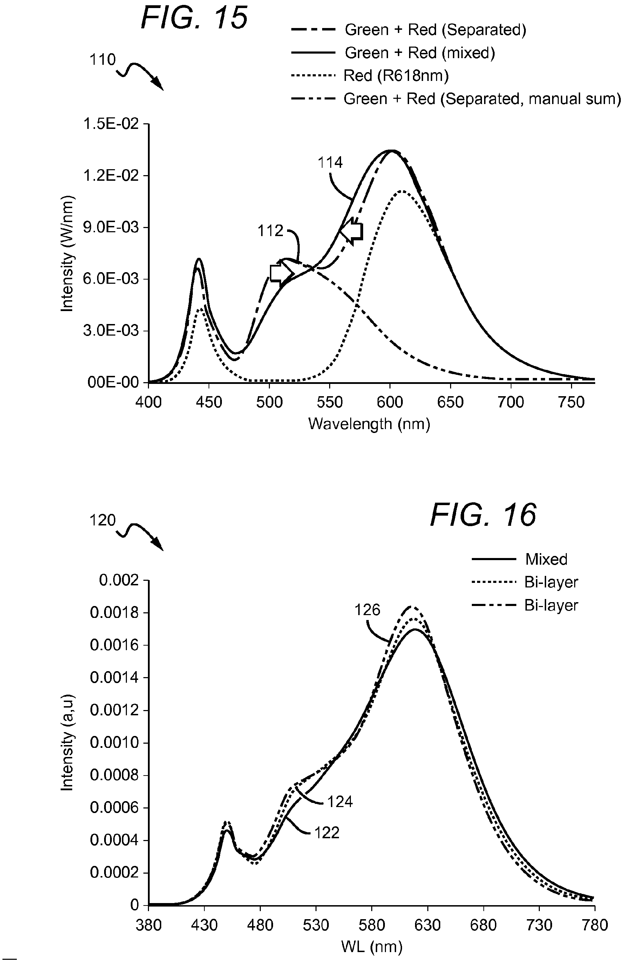

FIG. 15 is a graph 110 showing a comparison of the emission characteristics for an LED with mixed phosphor compared to a similar lamp with bi-layer separate phosphors as described above. In this embodiment, the first layer comprises a red phosphor with a peak emission of approximately 615nm, and the second layer can comprise a green phosphor. The first emission spectrum 112 is for a lamp with separated red and green phosphors, with the spectrum showing peaks in the blue, green and red wavelength spectrums. The second emission spectrum 114 is for a similar lamp with mixed red and green phosphors and shows a reduction and shift in the blue peak compared to the separated spectrum 112, as well as a shift in the red peak. The overall phosphor conversion efficiency for both is approximately the same, but the CRI for the separated is approximately 88.5 for separated phosphors verses 78.5 for the mixed phosphor configuration.

FIG. 16 shows another graph 120 showing a comparison of the emission characteristics for an LED with mixed phosphor compared so a similar bi-layer separate phosphor according to the present invention. Spectrum 122 shows the emission characteristics of an LED with mixed red and yellow/green phosphors, with the tow red phosphors in a 1 to 1 ratio. Spectrum 124 shows the emission characteristics of an LED with a bi-layer conversion material with the first red phosphor layer comprising two red phosphors in a 3 to 1 ratio. Spectrum 126 shows the emission characteristics of an LED with bi-layer conversion material with the first layer comprising only one red phosphor. Like the embodiment shown in FIG. 15, the mixed embodiment shows a shifting in the blue peak and the red peak. The bi-layer approach can result in the approximately the same or improved emission efficient while at the same time providing for an improved CRI.

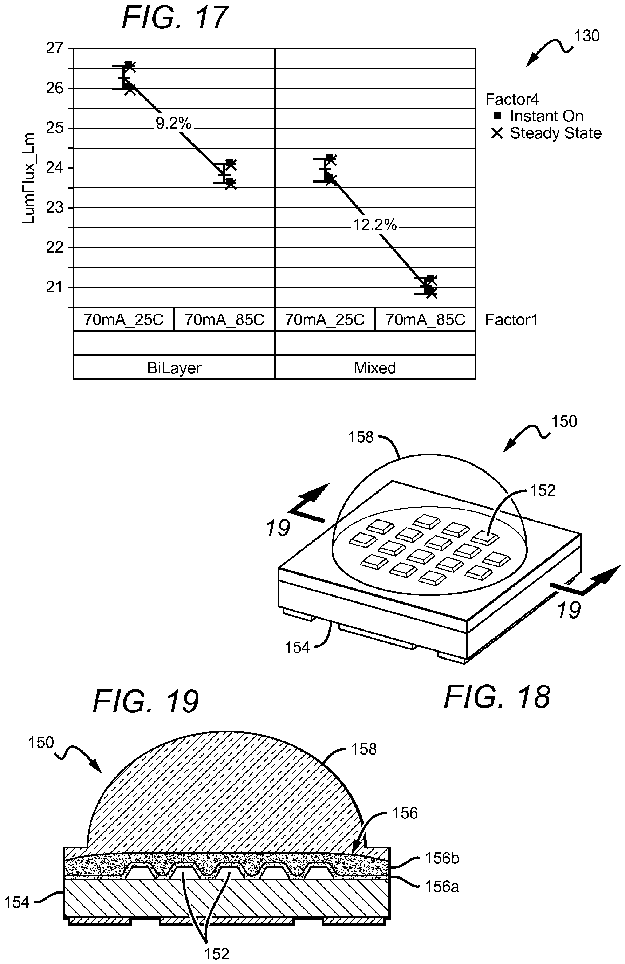

It is understood that others characteristics of LEDs can also vary when comparing bi-layer conversion material embodiments to conventional mixed conversion material embodiments. For example, the mixed comparative examples can experience a greater drop off in emission at increased operating temperature compared to the bi-layer approach. FIG. 17 is a graph 130 showing the emission characteristics of a bi-layer conversion LED compared to a mixed conversion LED though an operating temperature range of 25°C to 85°C. For the embodiment shown, the luminous flux of the mixed conversion LED drops off by greater than 10% over this temperature range, while the bi-layer embodiment drops off by less than 10%. In different embodiments, the drop off in luminous flux can be in the range of 20-30%, with the graph 130 showing the mixed conversion material layer LED having a drop off of 12.2% while the bi-layer embodiment has a drop-off of 9.2%.

The following lists some additional suitable phosphors that can be used as conversion particles, although others can be used. Each exhibits excitation in the blue and/or UV emission spectrum, provides a desirable peak emission, has efficient light conversion:
YELLOW/GREEN

   (Sr, Ca, Ba) (Al, Ga) ₂S₄ :Eu²⁺

   Ba₂ (Mg, Zn) Si₂O₇ Eu²⁺

   Gd_{0.46}Sr_{0.31}Al_{1.23}OₓF_{1.38}: Eu²⁺ _{0.6}

   (Ba_{1-x-y}SrₓCa_{y}) SiO₄: Eu

   Ba₂SiO₄= Eu²⁺
RED

   Lu₂O₃ = Eu³⁺

   (Sr₂₋ₓLaₓ) (Cei_{_x}Euₓ) O₄

   Sr₂C₁₋ₓEuₓO₄

   SrTiO₃:Pr³⁺, GA³⁺

   CaAlSiN₃IEu²⁺

   Sr₂Si₅N₈=Eu²⁺

In some embodiments, the layer comprising luminophoric material, the optical coupling layer and/or the optically transparent structure may also provide a functional layer which comprises a light scattering layer, which comprises a binder material as discussed above and light scattering particles, for example titanium oxide particles. In other embodiments, the layer comprises materials to alter the refractive index of the functional layer. In some embodiments, the functional layer comprises a combination of one or more of the types of functional layers described herein (e.g. a wavelength conversion layer and a scattering or refractive index altering layer).

Alternate wavelength conversion materials may also be used to down-convert light to generate white emissions. Such materials may be, but are not limited to organic fluorescent materials or dyes or inorganic quantum dot materials such as CdSe/ZnS, InP/InAs, CdS/CdSe, CdTe/CdSe or others.

The conversion material can comprise different sized phosphor particles including but not limited to particles in the range of 10 nanometers (nm) to 30 micrometers (µm), or larger. Smaller particle sizes typically scatter and mix colors better than larger sized particles to provide a more uniform light. Larger particles are typically more efficient at converting light compared to smaller particles, but emit a less uniform light.

The conversion material layer 56 can have many different thicknesses depending at least partially on the concentration of conversion material, the size of the conversion material particles, and the desired amount of light to be converted by the conversion material. Conversion material layer according to the present invention can be in a binder with phosphor concentration levels (phosphor loading) above 30%. Other embodiments can have concentration levels above 50%, while in still others the concentration level can be above 60%.

The LEDs according to the present invention can have many different relative thicknesses, with embodiments according to the invention comprising a first layer that is closest to the LED chip having the longest emission wavelength of the LED's phosphors. The second layer moving away from the LED chip(s) can be thicker and has a smaller emission wavelength than the first layer. Additional layers moving away from the LED chip can be thicker and/or can have smaller emission wavelengths than the layers below. In some embodiments the layers can become progressively thicker moving away from the LED chip, while in other embodiments the layers need only be thicker than the first layer. Likewise, in some embodiments the emission wavelengths of the layers can become progressively smaller moving away from the LED chip, with in other embodiments the emission wavelengths need only be smaller than the first layer's emission wavelength.

For LED 50, the bi-layer conversion material layer can have an overall thickness in the range of 50-500pm, with some embodiments having an overall in the range of 75-300pm and others having an overall thickness in the range of 100-200 pm. Thickness may also vary across the layer, with different regions having different thicknesses. The first conversion material layer 56a can be different percentages of the overall thickness of the conversion material layer. In some embodiments, the first layer 56a can comprise 5-30% of the overall thickness of the conversion material layer, while in other embodiments it can comprise 10-20% of the overall layer thickness. When measuring the thickness of the layers over the LED chips (or LED chip in other embodiments) the first layer can have many different thicknesses, such as in the range of approximately 10-70pm. Other embodiments having a thickness in the range of approximately 15-60pm and still other embodiments a thickness in the range of approximately 20-50pm. In some embodiments, the first layer over the LED chip can have a thickness greater than approximately 10pm, while other embodiments can have thicknesses greater than approximately 20pm. The thickness of the second layer over the LED chips can have a thickness in the range of approximately 40-400µm, with other embodiments having a thickness in the range of approximately 75-300pm. Still other embodiments can have a thickness in the range of approximately 90-250 pm. In some embodiments, the first layer can have a thickness greater than approximately 50pm, while other embodiments can have a thickness greater than approximately 100pm.

It is understood that these thicknesses and percentages can vary in different conversion material regions and that the conversion material layer can also have different regions in the respective layers with different concentrations of phosphor particles.

According to the invention, the first red phosphor layer comprises a substantial conformal coating over the LED chips, with the yellow/green conversion material layer covering the LED chips and filling gaps between the LEDs chips. In other embodiments not forming part of the invention, both layers can comprise a conformal coating or both layers can layer covering and substantially filling the gaps between adjacent LED chips.

It is understood that the different embodiments of the present invention can be arranged in many different ways beyond the embodiment shown above. By way of example, other embodiments can have different numbers, equal or greater than two, of LED chips coupled to solder pads and die attach pads in different ways, different encapsulants FIGs. 18 and 19 show another embodiment of LED 150 according to the present invention that comprises LED chips 152 on a submount 154. The submount 154 can comprise die attach pads and solder pads similar to those described above in LED 50. Instead of two LED chips, the LED 150 comprises an array of LED chips 152 and it is understood that the array can comprise many different numbers of LEDs coupled together in different parallel and serial arrangements. In the embodiment shown, array of LED chips 152 comprises 16 serially connected LED chips. The LED package is arranged similarly to the commercially available Cree^{®} XLamp^{®} XT-E High Voltage LED, with the LED 150 having a layered conversion material layer as described herein.

Like the embodiment above, the conversion material layer 156 comprises a bi-layer conversional material layer blanket covering the exposed top surfaces of the submount 154, die attach pads and the LED chips 152. According to the invention, the conversion material layer 156 comprises a first layer 156a that absorbs LED chip light and emits in the red spectrum, and a second layer 156b that absorbs LED chip light and emits light in the yellow/green wavelength spectrum. The LED chips can emit many different colors of light, and in some embodiments some of the LED chips can emit different colors of light than the others of the LED chips. In one embodiment, the LED chips 152 can emit blue light, with the LED 150 emitting a white light combination of LED chip light and conversion material light.

The bi-layer conversion material arrangement in LED 150 can provide the advantages discussed above in regards to LED 150, including but not limited to reduced red phosphor, tuning capabilities based on higher CRI, and different bi-layer recipes. According to the invention, the first red layer 156a forms a relatively thin layer that conformally coats over the LED chips 152. The yellow/green layer 156b is relatively thick and also covers the LED chips 152 and is thick enough to fill the space between adjacent ones of the LED chips 152. The resulting conversion material layer 156 can comprise a relatively smooth top surface, with the LED chips embedded in the conversion material layer 156. The conversion material layer 156 in LED 150 can have many different thicknesses, with the first layer 156a being different percentages of the overall layer thickness. In some embodiments, the conversion material layer can be in the range of 50-500µm, with the layer generally being thinner over the top of the LED chips 152 and thicker between and around the LED chips 152. In some embodiments, the conversion material layer can have a thickness in the range of 100-250µm. The thickness of the first layer 156a can be in range of 10-40% of the overall thickness of the conversion material layer 156. In still other embodiments it can be approximately 20-35% of the overall thickness. Some LED embodiments can comprise a first conversion material layer having a thickness less than 200pm, and a second conversion layer having a thickness greater than the first conversion material layer and less than 300pm.

The LED 150 also comprises an encapsulant 158 made of the same materials as the encapsulant 58 in LED 50 described above. In LED 150, however, the encapsulant has a generally hemispheric shape. It is understood that many different encapsulants can be used in this embodiment, including those with planar surfaces.

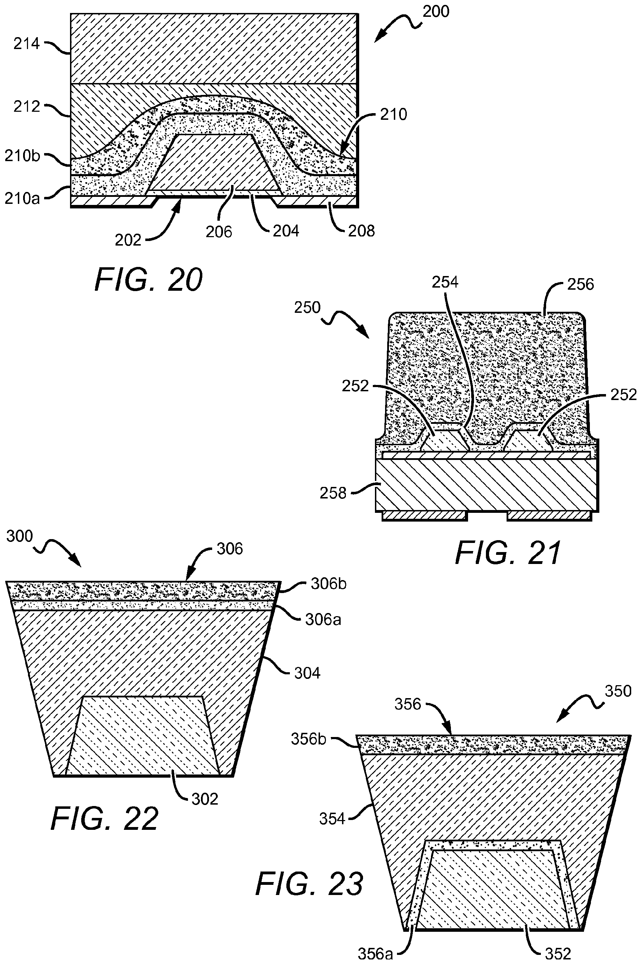

FIG. 20 shows an LED 200, not forming part of the invention, that can be provided without a submount. LED 200 is similar to LEDs devices described in U.S. Patent Application Serial No. 14/152,829, with the LED devices in this reference having mixed phosphor layers. The LED 200 includes a LED chip 202 that can comprise any of the LED chips described above, and generally includes a diode region 204 and a transparent substrate 206, such as a transparent silicon carbide growth substrate or a transparent sapphire growth substrate. The growth substrate may be removed. Another substrate may be provided that is different from the growth substrate, and the other substrate may be bonded to the LED epi region after removing the growth substrate.

The transparent substrate 206 may include angled sidewalls and the sidewalls may be stepped, beveled and/or faceted. Non-oblique sidewalls and approximately equal size faces may also be provided . For example, a square or rectangular chip with straight or non-oblique sidewalls may also be used. The LED 200 also comprises a reflective layer 208, which can below the bottom surface of the LED chip 202. This may also comprise a submount or any other feature.

A conversion material layer 210 is provided over the LED chip 202 and the reflective layer reflective layer. It is understood that the phosphor layer can be arranged in any of the ways described above, and comprises a bi-layer conversion material layer, with a first layer 210a on the LED chip 202 and a second layer 210b on the first layer 210a. The layers can comprise different conversion materials or phosphors as described above, having first layer 210a with a red phosphor and a second layer 210b with a yellow/green phosphor. The conversion material layer 210 can also comprise a light scattering material such as, for example, titanium oxide particles. The layer comprises materials to alter the refractive index of the layer.

The LED 200 also comprises an outer transparent layer 212 that provides a primary optic and can comprise any of the encapsulant materials described above, and the layer 212 can comprise silicone. The transparent layer 212 can be free of phosphors and may be shaped to provide a lens, dome and/or other optical components. The transparent layer 212 that is free of phosphor can also encapsulate the conversion material and/or the LED chip 202. The transparent layer may be provided on a phosphor layer that comprises phosphor particles that are non-uniformly dispersed therein. The device may further include an additional encapsulant or lens 214, which may be silicon or glass.

The bi-layer conversion material arrangement in LED 200 can comprise any of the materials described above that can be deposited using any of the methods described above. In LED 200, the bi-layer conversion material arrangement provides blanket coverage over the LED chip 202, with it is understood that one or both of the layers 210a, 210b can provide less than full blanket coverage as described above. The conversion material layer can have different thicknesses, with some having thicknesses in the range of 50-500µm. Still others can have thicknesses in the range of 50-300µm. The first layer 210a can comprise different percentages of the overall layer thickness, with some having a percentage in the range of 5-30%. In other s, the first layer can comprise a percentage in the range of 8-15%.

FIG. 21 shows an LED 250, not forming part of the invention, that is similar to the LED 50 described above and shown in FIGs. 4 to 11 and comprises many of the same features. However, the conversion material layer(s) and the encapsulant are arranged in different manner. For LED 250 the conversion material layer 254 comprises a single layer blanket covering the LED chips 252, the submount 258 and die attach pads as described above, although it can cover less than all of these features. The layer 254 absorbs light from the LED chips 252 and emits light in a particular wavelength spectrum such as in the red wavelength spectrum. The layer 254 can comprise the red emitting phosphors deposited in the different ways as described above. Instead of having a second conversion material layer on the first, the second conversion material is dispersed in the encapsulant 256. The dispersed conversion material can be one or more of the yellow/green phosphors described above. The phosphor can be dispersed evenly in the encapsulant or can having different areas with different concentrations.

The emission wavelength spectrum of the red phosphor layer can be outside of the excitation spectrum of the yellow/green phosphor so that it can pass through the yellow/green phosphor without being absorbed. By dispersing the yellow/green phosphor in the encapsulant, the likelihood of reemitted light from the yellow/green phosphor passing back into the red phosphor layer is reduced. This reduces the chance that the yellow/green light with be reabsorbed in the red layer.

It is understood that there can be many different layered and dispersed phosphor arrangements . There can be more than one phosphor layer over the LED chips used in conjunction with a dispersed phosphor. There can be one or more layers used in conjunction with an encapsulant having more than one dispersed phosphor. It is also understood that this layered/dispersed combination can be used in any of the different LEDs

Other LEDs invention can also provide separation between the LED chips and the layered conversion material layer or can provide separation between ones of the layers in the layered conversion material layer. FIG. 22 shows an LED 300, not forming part of the invention, comprising an LED chip 302 that can be any of the LED chips described above. A transparent encapsulant 304 is included over the LED chip 302 that can also comprise any of the materials described above. The encapsulant 304 can take many different shapes and sizes with the embodiment shown having angled side surfaces such that the top of the encapsulant 304 is wider than the portion close to the LED chip 302.

A second conversion material layer 306 is also included on the top surface of the encapsulant that can comprise the materials described above and can be deposited using the methods described above. Like above, the conversion layer can be bi-layered with the first layer (closed to the LED chip) 306a comprising a phosphor that absorbs light from the LED chip 302 and reemits light in the red wavelength spectrum. A second layer 306b can be on the first layer 306a and can comprise a phosphor that absorbs LED chip light and emits light in the yellow/green spectrum. The LED 300 can emit the desired white light combination of LED chip light and light from the first and second layer 306a, 306b.

FIG. 23 shows an LED 350, not forming part of the invention, that is similar to LED 300, and comprises an LED chip 352 and an encapsulant 354. The conversion material comprises two layers, but the layers are separate by the encapsulant 354. The first conversion material layer 356a directly covers the LED chip 352 and can comprise a red emitting phosphor as described above. The second conversion material layer 356b can be separated from the first layer 356a and can be on the top surface of the encapsulant 354. The second layer can comprise a yellow/green emitting phosphor. Separating the first and second layers 356a, 356b further reduces the amount of yellow/green light from the second layer 356b that might pass into the first layer 356a. This further reduces the chances the yellow/green light might be reabsorbed by the first layer. This can further increase the emission efficiency of the LED 350.

It is understood that these LED can be arranged in many different ways with the encapsulants, with other s used with more than two layers arranged in different locations in the LED. Some can have more than one layer on the LED chip, on the top surface of the encapsulant, or can have one or more layers embedded within the encapsulant. Still others can have one or more phosphors dispersed in the encapsulant.

A bi-layer approach can use less than four, with some having one of the layers with two phosphors emitting in the red or yellow/green spectrum, with the other layer having one red phosphor or yellow/green phosphor.

Other embodiments not forming part of the invention can utilize only two phosphors, with the first layer having one phosphor emitting in the red spectrum and the second layer having one phosphor emitting in the yellow/green spectrum. The two phosphors can be tailored to achieve the desired emission characteristics with fewer different phosphors. As described above, LEDs with single layer mixed phosphor deposition do not exhibit the same benefits compared to LEDs having first layer of single red phosphor and then a layer of a single yellow/green phosphor. A first, relatively thin layer of red phosphor can be applied first with an optical silicone, with the phosphor having a peak wavelength of ~630um. A thicker second layer of green phosphor having a peak wavelength of ~539 can then be applied on the first layer. This combination can result in an LED that emits light in the E7 color region, with a CRI >90, CRI9 >40 and a brightness increase of approximately 15%, compared to the same LED with a single mixed layer of the same two phosphors.

If the same red and green phosphors are used in an LED in a mixed single layer approach, the CRI of light emitted by the LED will not reach 90. Reaching a CRI of 90 in mixed layer LED can require 3 or 4 phosphors, with some utilising one or more additional phosphors such as an additional red phosphor with a peak wavelength of ~651nm. Some embodiments not forming part of the invention can include other additional phosphors, such as one or more yellow and green phosphors. However, for some LEDs the addition of a yellow phosphor to the two red and one green phosphor combination may not significantly add to the LED's ability to reach emission with a CRI of 90. In these embodiments, two reds have the greatest impact on the ability of the LED chip to reach a CRI of 90 in a single mixed layer system, which can be one of the reasons that the mixed layer system emits a lower luminous flux.

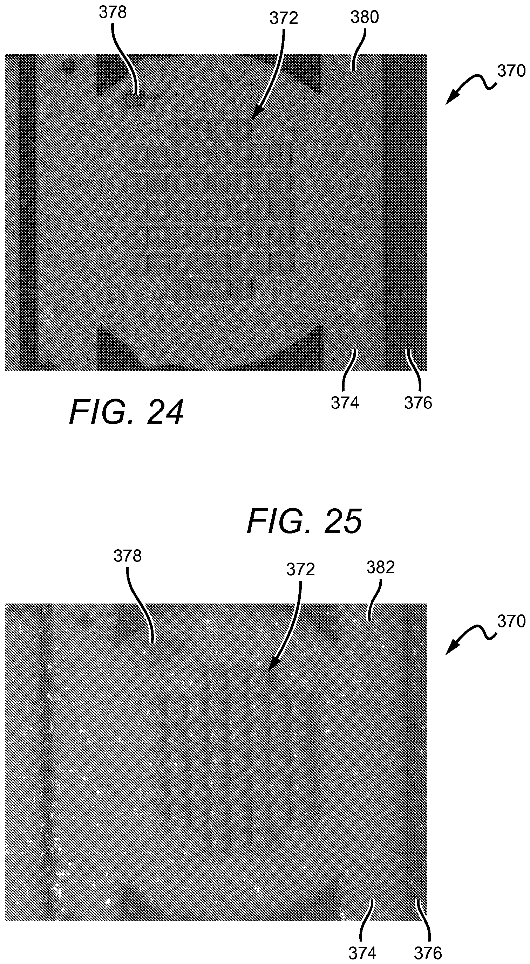

FIGs. 24 and 25 show another embodiment of an LED 370 not forming part of the present invention at different points during its manufacturing. The LED 370 comprises a plurality of LED chips 372 mounted on die attach pad 374. Different embodiments can have different numbers of LED chips 372, with the embodiment shown having 48. The LEDs can comprise and of the chips listed above, and can emit at different wavelengths and with different characteristics as those described above. The LED chips 372 can be connected in series, parallel or in different series/parallel combinations. The die attach pad 374 can be arranged on a submount 376 as described above, and the LED 370 can comprise other elements, such as an ESD chip 378.

Referring now to FIG. 24, the LED 370 can comprise a first phosphor layer 380 comprising a red layer of phosphor with a peak wavelength of ~630um. The red phosphor layer 380 can provide blanket coverage over the LED chips 372, attach pads 374 and submount 376 as described above. However, the red phosphor layer 380 does not provide a solid blanket covering, but instead is provided with irregular coverage. Irregular generally refers to the layer 380 not having a uniform thickness. In some embodiments not forming part of the invention the layer 380 can be discontinuous and may not provide coverage over portions of the LED chips 372, attach pads 374 and submount 376. In these embodiments the discontinuous nature of the layer 380 can be random, while in other embodiments the discontinuities can have some order or pattern. For all these embodiments, the red phosphor is provided in the appropriate amount of red for the targeted emission characteristics. More evenly deposited red phosphor can result in better color targeting, but even deposition is not required. More even deposition can be achieved through optimizing atomization during the deposition process.

Referring now to FIG. 25, a second layer 382 of green phosphor having a peak wavelength of ~539 is deposited over the first red phosphor layer 380. The second layer 382 is thicker than the first layer 380, and is also applied in a conformal manner. However, the second layer 382 provides blanket coverage over the LED chips 372, attach pad 374, and the submount 376. The first and second layers 380, 382 can be arranged with different materials with the embodiment shown having a relatively small amount of fumed silica of less that 1% per silicone weight. In some embodiments, the layers can have fumed silica in the amount of approximately 0.75% per silicone weight. Fumed silica is mixed with the phosphors aid in the LED reaching the target emission. This may not be required for the performance results, but is recommended for consistency of application. The LED 370 can also comprise an encapsulant that can be formed during a subsequent formation step, and the encapsulant can comprise any of the materials, shapes and sizes described above.

The embodiments presented herein are meant to be exemplary.

Although the present invention has been described in detail with reference to certain preferred configurations thereof, other versions are possible. Therefore, the scope of the invention should not be limited to the versions described above. The invention is defined by the appended claims.

## Claims

1. An LED, comprising:
two or more LED chips (52, 152) on a surface of a submount (54, 154);
a conversion material layer (56, 156) comprising at least first (56a, 156a) and second (56b, 156b) layers of different conversion materials, said first and second conversion material layers covering said two or more LED chips and at least a portion of said submount around said two or more LED chips, said at least first and second conversion material layers being arranged such that said first conversion material layer is closest to said two or more LED chips and has an emission spectrum that does not overlap with the excitation spectrum of said second conversion material layer; and
an encapsulant (58, 158) over said two or more LED chips and said submount;
**characterised in that**
said first conversion material layer conformally coats said two or more LED chips and said second conversion material layer blanket covers said two or more LED chips and the areas of said submount surrounding said two or more LED chips, and fills gaps between said two or more LED chips, said second conversion material layer covering said first conversion material layer; and
wherein said first conversion material layer comprises a layer of red emitting phosphor and said second conversion material layer comprises a layer of yellow/green emitting phosphor.

2. The LED of claim 1, wherein said red emitting phosphor layer is directly on said two or more LED chips and said yellow/green emitting phosphor layer is directly on said red emitting phosphor layer.

3. The LED of claim 1, wherein said encapsulant comprises planar surfaces.

4. The LED of claim 1, wherein said first conversion material layer and said second conversion material layer blanket cover said submount.

5. The LED of claim 1, further comprising a reflective layer between said at least first and second conversion material layers and said submount.

6. The LED of claim 1, wherein less emitted light from said yellow/green phosphor layer passes through a red phosphor compared to the same LED comprising a conversion material layer with mixed red and yellow/green phosphors.

7. The LED of claim 1, wherein less emitted light from said yellow/green phosphor layer is absorbed by said red phosphor layer compared to the same LED comprising a conversion material with mixed red and yellow/green phosphors.

8. The LED of claim 1, emitting light at a higher CRI compared to the same LED comprising a conversion material with mixed red and yellow/green phosphors with the same amount of red and yellow phosphors.

9. The LED of claim 1, wherein said encapsulant is hemispheric.

10. The LED of claim 1, wherein said first conversion material layer and said second conversion material layer blanket cover all of said submount.

11. The LED of claim 1, wherein said encapsulant is over said first and second conversion material layers.

## Patentansprüche

1. Eine LED, die Folgendes umfasst:
zwei oder mehr LED-Chips (52, 152) auf einer Oberfläche eines Submounts (54, 154);
eine Umwandlungsmaterialschicht (56, 156), die mindestens erste (56a, 156a) und zweite (56b, 156b) Schichten verschiedener Umwandlungsmaterialien umfasst, wobei die ersten und zweiten Umwandlungsmaterialschichten die zwei oder mehr LED-Chips und mindestens einen Teil des Submounts um die zwei oder mehr LED-Chips herum bedecken, wobei die mindestens ersten und zweiten Umwandlungsmaterialschichten so angeordnet sind, dass die erste Umwandlungsmaterialschicht den zwei oder mehr LED-Chips am nächsten ist und ein Emissionsspektrum hat, das sich nicht mit dem Anregungsspektrum der zweiten Umwandlungsmaterialschicht überlagert; und
ein Verkapselungsmittel (58, 158) über den zwei oder mehr LED-Chips und dem Submount;
**dadurch gekennzeichnet, dass**
die erste Umwandlungsmaterialschicht die zwei oder mehr LED-Chips konform bedeckt und die zweite Umwandlungsmaterialschicht-Abdeckung die zwei oder mehr LED-Chips und die Bereiche des Submounts bedeckt, die die zwei oder mehr LED-Chips umgeben, und Lücken zwischen den zwei oder mehr LED-Chips füllt, wobei die zweite Umwandlungsmaterialschicht die erste Umwandlungsmaterialschicht bedeckt; und
wobei die erste Umwandlungsmaterialschicht eine Schicht rot abstrahlenden Phosphor umfasst und die zweite Umwandlungsmaterialschicht eine Schicht gelb/grün abstrahlenden Phosphor umfasst.

2. Die LED gemäß Anspruch 1, wobei die rot abstrahlende Phosphorschicht direkt auf den zwei oder mehr LED-Chips liegt und die gelb/grün abstrahlende Phosphorschicht direkt auf der rot abstrahlenden Phosphorschicht liegt.

3. Die LED gemäß Anspruch 1, wobei das Verkapselungsmittel planare Oberflächen umfasst.

4. Die LED gemäß Anspruch 1, wobei die erste Umwandlungsmaterialschicht und die zweite Umwandlungsmaterialschicht-Abdeckung das Submount bedecken.

5. Die LED gemäß Anspruch 1, die weiter eine reflektierende Schicht zwischen den mindestens ersten und zweiten Umwandlungsmaterialschichten und dem Submount umfasst.

6. Die LED gemäß Anspruch 1, wobei weniger abgestrahltes Licht von der gelben/grünen Phosphorschicht durch einen roten Phosphor dringt als bei derselben LED, die eine Umwandlungsmaterialschicht mit gemischten roten und gelben/grünen Phosphoren umfasst.

7. Die LED gemäß Anspruch 1, wobei weniger abgestrahltes Licht von der gelben/grünen Phosphorschicht von der roten Phosphorschicht absorbiert wird als bei derselben LED, die ein Umwandlungsmaterial mit gemischten roten und gelben/grünen Phosphoren umfasst.

8. Die LED gemäß Anspruch 1, die Licht mit einem höheren CRI ausstrahlt als dieselbe LED, die ein Umwandlungsmaterial mit gemischten roten und gelben/grünen Phosphoren mit derselben Menge roter und gelber Phosphore umfasst.

9. Die LED gemäß Anspruch 1, wobei das Verkapselungsmittel halbkugelförmig ist.

10. Die LED gemäß Anspruch 1, wobei die erste Umwandlungsmaterialschicht und die zweite Umwandlungsmaterialschicht-Abdeckung das gesamte Submount bedecken.

11. Die LED gemäß Anspruch 1, wobei sich das Verkapselungsmittel über der ersten und der zweiten Umwandlungsmaterialschicht befindet.

## Revendications

1. DEL, comprenant :
deux puces DEL ou plus (52, 152) sur une surface d'une embase (54, 154) ;
une couche de matériau de conversion (56, 156) comprenant au moins des première (56a, 156a) et seconde (56b, 156b) couches de différents matériaux de conversion, lesdites première et seconde couches de matériau de conversion recouvrant lesdites deux puces DEL ou plus et au moins une partie de ladite embase autour desdites deux puces DEL ou plus, lesdites au moins première et seconde couches de matériau de conversion étant agencées de telle sorte que ladite première couche de matériau de conversion soit la plus proche desdites deux puces DEL ou plus et ait un spectre d'émission qui ne chevauche pas le spectre d'excitation de ladite seconde couche de matériau de conversion ; et
un encapsulant (58, 158) au-dessus desdites deux puces DEL ou plus et de ladite embase ;
**caractérisée en ce que** ladite première couche de matériau de conversion revêt de manière enrobante lesdites deux puces DEL ou plus et ladite seconde couche de matériau de conversion recouvre complètement lesdites deux puces DEL ou plus et les zones de ladite embase entourant lesdites deux puces DEL ou plus, et remplit des vides entre lesdites deux puces DEL ou plus, ladite seconde couche de matériau de conversion recouvrant ladite première couche de matériau de conversion ; et
dans laquelle ladite première couche de matériau de conversion comprend une couche de luminophore émettant dans le rouge et ladite seconde couche de matériau de conversion comprend une couche de luminophore émettant dans le jaune/vert.

2. DEL selon la revendication 1, dans laquelle ladite couche de luminophore émettant dans le rouge est directement sur lesdites deux puces DEL ou plus et ladite couche de luminophore émettant dans le jaune/vert est directement sur ladite couche de luminophore émettant dans le rouge.

3. DEL selon la revendication 1, dans laquelle ledit encapsulant comprend des surfaces planes.

4. DEL selon la revendication 1, dans laquelle ladite première couche de matériau de conversion et ladite seconde couche de matériau de conversion recouvrent complètement ladite embase.

5. DEL selon la revendication 1, comprenant en outre une couche réfléchissante entre lesdites au moins première et seconde couches de matériau de conversion et ladite embase.

6. DEL selon la revendication 1, dans laquelle moins de lumière émise par ladite couche de luminophore jaune/vert passe à travers un luminophore rouge par comparaison à la même DEL comprenant une couche de matériau de conversion à luminophores rouge et jaune/vert mélangés.

7. DEL selon la revendication 1, dans laquelle moins de lumière émise par ladite couche de luminophore jaune/vert est absorbée par ladite couche de luminophore rouge par comparaison à la même DEL comprenant un matériau de conversion à luminophores rouge et jaune/vert mélangés.

8. DEL selon la revendication 1, émettant de la lumière à un plus haut IRC par comparaison à la même DEL comprenant un matériau de conversion à luminophores rouge et jaune/vert mélangés ayant la même quantité de luminophores rouge et jaune.

9. DEL selon la revendication 1, dans laquelle ledit encapsulant est hémisphérique.

10. DEL selon la revendication 1, dans laquelle ladite première couche de matériau de conversion et ladite seconde couche de matériau de conversion recouvrent complètement la totalité de ladite embase.

11. DEL selon la revendication 1, dans laquelle ledit encapsulant est au-dessus desdites première et seconde couches de matériau de conversion.
